# EUROPEAN PATENT APPLICATION

(11) **EP 4 372 814 A1**
(43) Date of publication of application: **22.05.2024**
(21) Application number: 23210397.8
(22) Date of filing: 16.11.2023
(51) Int. Cl.: H01L 23/522, H04B 5/26

(54) **INTEGRATED CIRCUIT PROVIDING GALVANIC ISOLATION AND DEVICE INCLUDING THE SAME**

(30) Priority: 18.11.2022 KR 20220155818
(71) Applicant: Wellang Co., Ltd., Seongnam-si, Gyeonggi-do 13486 (KR)
(72) Inventor: HWANG, Jong Tae, 06292 SEOUL (KR)
(74) Representative: Cristinelli, Luca

(57) **Abstract**

Provided is a device including a first integrated circuit, wherein the first integrated circuit includes a first inductor comprising a first pattern disposed in a first conductive layer, and a first capacitor comprising a first electrode disposed in the first conductive layer and electrically connected to the first inductor and a second electrode disposed in a second conductive layer above the first conductive layer and electrically connected to a first bonding wire.

## Description

### CROSS-REFERENCE TO RELATED APPLICATION

This application is based on and claims priority under 35 U.S.C. §119 to Korean Patent Application No. 10-2022-0155818, filed on November 18, 2022, in the Korean Intellectual Property Office, the disclosure of which is incorporated by reference herein in its entirety.

### BACKGROUND

### 1. Field

The disclosure relates to an integrated circuit and a device, and particularly, to an integrated circuit providing galvanic isolation and a device including the integrated circuit.

### 2. Description of the Related Art

An isolation driver may be used for transmitting and receiving signals between circuits having different reference potentials. For example, galvanic isolation refers to allowing transmission of signals by blocking a current flow among circuits having different reference potentials, and an isolation driver based on galvanic isolation may be referred to as a galvanic isolator. The demand for isolation drivers is increasing in various applications, and accordingly, a galvanic isolator having high efficiency and reliability is required.

### SUMMARY

Provided are an integrated circuit having high efficiency and reliability and providing galvanic isolation, and a device including the integrated circuit.

Additional aspects will be set forth in part in the description which follows and, in part, will be apparent from the description, or may be learned by practice of the presented embodiments.

According to an embodiment, a device includes a first integrated circuit, wherein the first integrated circuit includes a first inductor including a first pattern disposed in a first conductive layer, and a first capacitor including a first electrode disposed in the first conductive layer and electrically connected to the first inductor and a second electrode disposed in a second conductive layer above the first conductive layer and electrically connected to a first bonding wire.

The first electrode may be surrounded by the first pattern in the first conductive layer and overlap the second electrode in a vertical direction.

The first integrated circuit may include a second inductor including a second pattern disposed in the first conductive layer and electrically connected to the first inductor and a second capacitor including a third electrode disposed in the first conductive layer and electrically connected to the second inductor and a fourth electrode disposed in the second conductive layer and electrically connected to a second bonding wire.

The third electrode may be surrounded by the second pattern and overlap the fourth electrode in a vertical direction.

The first integrated circuit may further include a third pattern disposed in the first conductive layer and connected to the first pattern and the second pattern, and the third pattern may be electrically connected to a low impedance node.

The first integrated circuit may further include a capacitor configured to generate a signal having a resonant frequency based on the first inductor and the second inductor.

The first inductor may further include a fourth pattern disposed in the second conductive layer, at least one fifth pattern disposed in at least one conductive layer between the first conductive layer and the second conductive layer, and vias connecting two adjacent patterns to each other among the first pattern, the fourth pattern, and the at least one fifth pattern.

A distance between the fourth pattern and the second electrode may be greater than or equal to a distance between the first electrode and the second electrode.

The device may further include a second integrated circuit apart from the first integrated circuit, wherein the first bonding wire connects the first integrated circuit to the second integrated circuit.

The second integrated circuit may include an inductor having a structure identical to the first inductor and a capacitor having a structure identical to the first capacitor.

The second integrated circuit may further include a third inductor disposed in a third conductive layer, a fourth inductor including a sixth pattern disposed in a fourth conductive layer above the third conductive layer and inductively coupled to the first inductor, and a pattern surrounded by the sixth pattern and electrically connected to the fourth inductor and the first bonding wire.

According to another embodiment, a device includes a first integrated circuit, wherein the first integrated circuit includes a first inductor including a first pattern disposed in a first conductive layer, a second inductor disposed in a second conductive layer above the first conductive layer and inductively coupled to the first inductor, and a first capacitor including a first electrode disposed in the first conductive layer and electrically connected to the first inductor and a second electrode disposed in the second conductive layer and electrically connected to a first bonding wire, wherein the second electrode is insulated from the second inductor.

The first integrated circuit may further include a third inductor including a second pattern disposed in the first conductive layer, a fourth inductor disposed in the second conductive layer and inductively coupled to the third inductor, and a second capacitor including a third electrode disposed in the first conductive layer and electrically connected to the third inductor and a fourth electrode disposed in the second conductive layer and electrically connected to a second bonding wire, wherein the third electrode may be insulated from the fourth inductor.

The first integrated circuit may further include a third pattern disposed in the first conductive layer and connecting the first pattern to the second pattern, and the third pattern may be electrically connected to a low impedance node.

The first integrated circuit may further include a capacitor configured to generate a signal having a resonant frequency based on the second inductor and the fourth inductor.

The first inductor may further include at least one fourth pattern disposed in at least one conductive layer between the first conductive layer and the second conductive layer, and vias connecting two adjacent patterns to each other among the first pattern and the at least one fourth pattern.

The first electrode may be surrounded by the first pattern in the first conductive layer, and the second electrode may be surrounded by the second inductor in the second conductive layer.

A distance between the second inductor and the second electrode may be greater than or equal to a distance between the first electrode and the second electrode.

The device may further include a second integrated circuit apart from the first integrated circuit, wherein the first bonding wire connects the first integrated circuit to the second integrated circuit.

The second integrated circuit may include a fifth inductor having a structure identical to the first inductor, a sixth inductor having a structure identical to the second inductor, and a third capacitor having a structure identical to the first capacitor.

The second integrated circuit may include a seventh inductor including a fifth pattern disposed in a third conductive layer, and a fourth capacitor including a fifth electrode disposed in the third conductive layer and electrically connected to the seventh inductor and a sixth electrode disposed in a fourth conductive layer above the third conductive layer and electrically connected to the first bonding wire, wherein the fifth electrode may be surrounded by the fifth pattern in the third conductive layer and overlap the sixth electrode in a vertical direction

The second integrated circuit may include an eighth inductor disposed in a fifth conductive layer, a ninth inductor including a sixth pattern disposed in a sixth conductive layer above the fifth conductive layer and inductively coupled to the first inductor, and a pattern surrounded by the sixth pattern and electrically connected to the ninth inductor and the first bonding wire.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram of a system according to an embodiment;
FIG. 2 is a timing diagram illustrating signals shown in FIG. 1, according to an embodiment;
FIGS. 3A to 3C are each a circuit diagram illustrating an example of a galvanic isolator, according to embodiments;
FIGS. 4A to 4C are each a perspective view illustrating an example of a galvanic isolator, according to embodiments;
FIG. 5 is a cross-sectional view of the galvanic isolator taken along line X1-X1' of FIG. 4C, according to an embodiment;
FIGS. 6A to 6C are each a perspective view illustrating an example of a galvanic isolator, according to embodiments;
FIG. 7 is a cross-sectional view of the galvanic isolator taken along line X1-X1' of FIG. 6C, according to an embodiment;
FIG. 8 is a perspective view illustrating an example of the galvanic isolator according to an embodiment;
FIG. 9 is a cross-sectional view of the galvanic isolator taken along line X1-X1' of FIG. 8, according to an embodiment; and
FIGS. 10A to 10H are each a diagram illustrating an example of a device, according to embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments of the disclosure are described in detail with reference to the accompanying drawings. The embodiment of the disclosure is provided to fully explain the disclosure to those with average knowledge in the industry. As the disclosure allows for various changes and numerous embodiments, certain embodiments will be illustrated in the drawings and described in detail. However, it should be understood that the disclosure is not limited to a specific disclosed form, but includes all changes, equivalents, or alternatives included in the ideas and technical scope of the disclosure. In each drawing, similar reference numbers are used for similar elements. In the accompanying drawings, the dimensions of the structures are expanded or reduced compared to the actual size.

The term used herein is used to explain a particular embodiment, and is not intended to limit the disclosure. The singular forms include the plural forms unless the context clearly indicates otherwise. In the disclosure, terms such as "include" or "have" are intended to designate that there are features, numbers, steps, operations, components, parts, or combinations thereof described in the specification, but it should be understood that the term does not preclude the possibility of the presence or addition of one or more other features, numbers, steps, operations, components, parts, or combinations thereof.

Unless defined otherwise, all terms used herein, including technical or scientific terms, have the same meaning as commonly understood by one of ordinary skill in the art to which the present disclosure belongs. Terms such as those defined in commonly used dictionaries should be interpreted as having a meaning consistent with the meaning in the context of the related art, and unless explicitly defined in the present disclosure, the terms are not to be construed in an idealized or overly formal sense.

Herein, an X-axis direction and a Y-axis direction may be referred to as the first horizontal direction and the second horizontal direction, respectively, and a Z-axis direction may be referred to as the vertical direction. A plane including the X-axis and Y-axis may be referred to as a horizontal surface, an element arranged relatively to a +Z direction may be referred to as being above another element, and an element arranged relatively to a -Z direction may be referred to as being under another element. In addition, an area of an element may refer to the size occupied by the element in a surface parallel to a horizontal surface, and a width of an element may refer to the length in a direction orthogonal to an extending direction of the element. A surface exposed in the +Z direction may be referred to as a top surface, a surface exposed in the -Z direction may be referred to as a bottom surface, and a surface exposed in the ±X direction or the ±Y direction may be referred to as a side surface. For convenience of illustration, only a few layers may be shown in the drawings, and patterns including conductive materials, such as patterns of conductive layers such as wiring layers, may be referred to as conductive patterns or simply referred to as patterns.

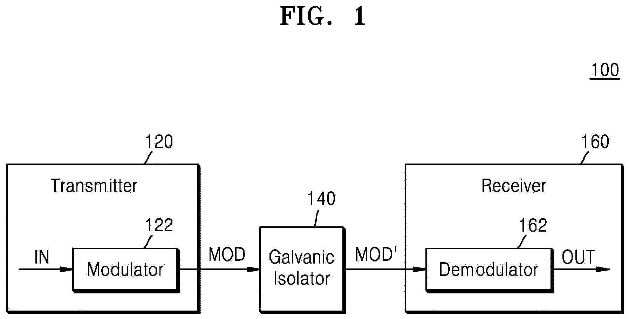

FIG. 1 is a block diagram of a system 100 according to an embodiment. As shown in FIG. 1, the system 100 may include a transmitter 120, a galvanic isolator 140, and a receiver 160. The transmitter 120 and the receiver 160 may each include different reference potentials (for example, GND1 and GND2 shown in FIG. 1 0A), and the galvanic isolator 140 may deliver signals including information between the transmitter 120 and the receiver 160. Herein, the system 100 may be referred to as a device.

In some embodiments, the system 100 may be an electronic apparatus such as a TV, a personal computer (PC), etc., a transportation such as a vehicle, a personal mobility (PM), etc., or components included in the examples mentioned above. In some embodiments, the system 100 may correspond to a semiconductor package manufactured by a semiconductor process. For example, the transmitter 120, the galvanic isolator 140, and the receiver 160 may be included in at least one integrated circuit (a chip or die), and the system 100 may correspond to a semiconductor package in which at least one integrated circuit is packaged. As described below with reference to the drawings, galvanic isolation may be provided by a single semiconductor package, and accordingly, galvanic isolation may be easily employed in various applications.

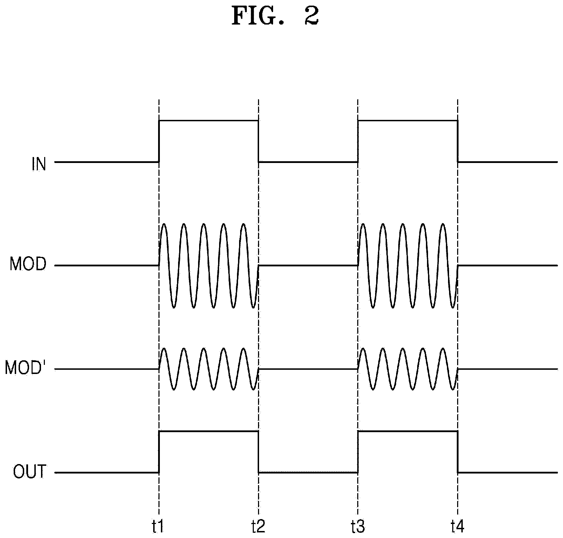

The transmitter 120 may include a modulator 122. The modulator 122 may receive an input signal IN and may generate a modulated signal MOD by modulating the input signal IN. In some embodiments, the modulator 122 may generate a modulated signal MOD from the input signal IN based on on/off keying (OOK). The input signal IN may include information to be provided to the receiver 160 and may be generated inside the transmitter 120 or received from the outside of the transmitter 120. In some embodiments, the galvanic isolator 140 may include an inductor, and the modulator 122 may generate the modulated signal MOD by using a resonant frequency based on the inductor included in the galvanic isolator 140. An example of an input signal IN and a modulated signal MOD will be described below with reference to FIG. 2.

The galvanic isolator 140 may receive a modulated signal MOD from the transmitter 120 and may generate an induced signal MOD' from the modulated signal MOD. In some embodiments, the induced signal MOD' may correspond to a signal attenuated from the modulated signal MOD. As described below with reference to the drawings, the galvanic isolator 140 may include a capacitor and an inductor connected in series to each other, and the inductor and the capacitor may be implemented in one integrated circuit. The modulated signal may be transmitted by using an inductively coupled inductor and the physical distance between the inductors may be ensured to satisfy the isolation voltage. Similarly, the modified signal may be transmitted by using a capacitor, and the distance between electrodes at both ends of the capacitor may be ensured to satisfy the isolation voltage.

The receiver 160 may include a demodulator 122. The demodulator 162 may receive the induced signal MOD' and generate an output signal OUT by demodulating the induced signal MOD'. In some embodiments, the demodulator 162 may generate an output signal OUT from the induced signal MOD' based on OOK. The output signal OUT may include information included in the input signal IN. In some embodiments, a driver that amplifies the output signal OUT may be included in the receiver 160 or may be included in the system 100 outside the receiver 160. In some embodiments, the galvanic isolator 140 may include an inductor, and the demodulator 162 may process the induced signal MOD' by using a resonant frequency based on the inductor included in the galvanic isolator 140.

FIG. 2 is a timing diagram illustrating the signals of FIG. 1, according to an embodiment. FIG. 2 shows only an example, and it should be understood that the signals shown in FIG. 1 are not limited to the example of FIG. 2. For convenience of illustration, the delay between the signals is ignored in FIG. 2. Hereinafter, FIG. 2 will be described with reference to FIG. 1.

Referring to FIG. 2, the input signal IN may be a pulse signal having an active state or an inactive state. For example, as shown in FIG. 2, the input signal IN may be activated in time t1 and time t3 and be inactivated in time t2 and time t4. The modulator 122 may generate a modulated signal MOD oscillating in response to the activation of the input signal IN. For example, as shown in FIG. 2, the modulated signal MOD may oscillate from time t1 to time t2 and oscillate from time t3 to time t4.

The galvanic isolator 140 may generate a oscillating induced signal MOD' from a oscillated modulated signal MOD. For example, as shown in FIG. 2, the induced signal MOD' may oscillate from time t1 to time t2 and oscillate from time t3 to time t4. As shown in FIG. 2, the size of the induced signal MOD' (i.e., the amplitude or peak) may be smaller than that of the modulated signal MOD. The demodulator 162 may generate an activated output signal OUT in response to the oscillating induced signal MOD'. For example, as shown in FIG. 2, the output signal OUT may be activated from time t1 to time t2 and be activated from time t3 to time t4.

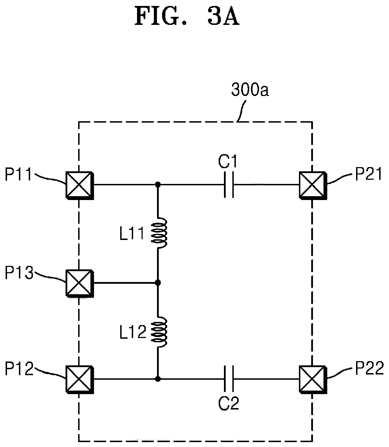

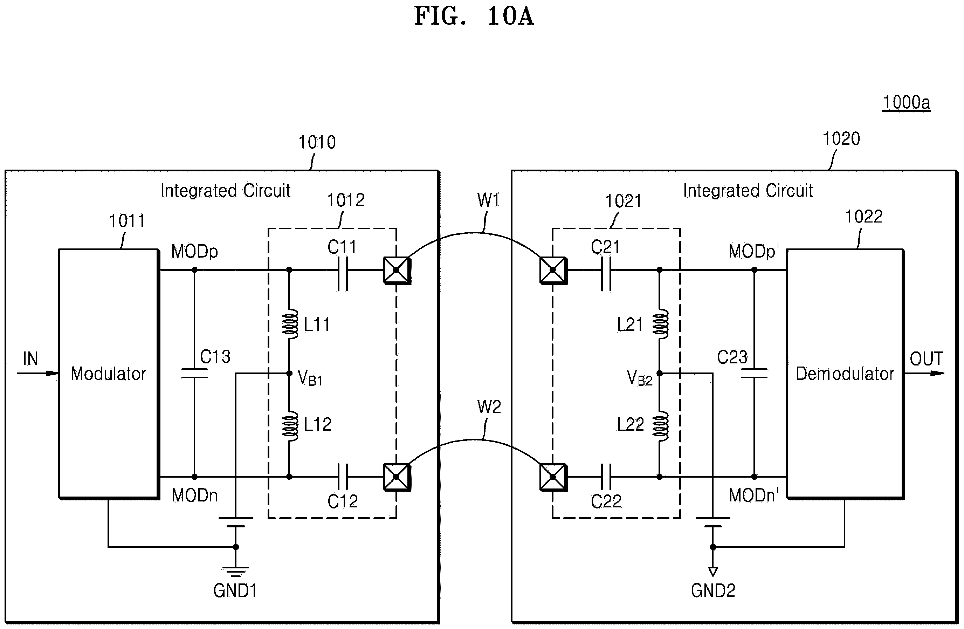

FIGS. 3A to 3C are each a circuit diagram illustrating an example of the galvanic isolator, according to an embodiment. For example, the circuit diagrams of FIGS. 3A to 3C show equivalent circuits of the galvanic isolator 140 of FIG. 1. In some embodiments, as described below with reference to FIGS. 10A to 10H, the galvanic isolator 140 of FIG. 1 may include a structure wherein at least two of galvanic isolators 300a, 300b, and 300c of FIGS. 3A to 3C are cascaded. Hereinafter, the descriptions of aspects that overlap each other in FIGS. 3A to 3C will be omitted.

In some embodiments, the modulated signal MOD and the induced signal MOD' of FIG. 1 may be differential signals, and each of the galvanic isolators 300a, 300b, and 300c may include terminals P11 and P12 for receiving the modulated signal MOD and terminals P21 and P22 for outputting the induced signal MOD'. In addition, each galvanic isolator 300a, 300b, and 300c may include a center tab terminal P13, and the center tab terminal P13 may be connected to a low impedance node. In some embodiments, the modulated signal MOD may be applied to the terminals P21 and P22, and the induced signal MOD' may be output to the terminals P11 and P12. As shown in FIGS. 3A to 3C, the galvanic isolators 300a, 300b, and 300c may have a balanced structure for differential signals.

Referring to FIG. 3A, the galvanic isolator 300a may include a first inductor L1 and a second inductor L2 connected in series to each other. In addition, the galvanic isolator 300a may include a first capacitor C1 between the terminal P11 and the terminal P21 and may include a second capacitor C2 between the terminal P12 and the terminal P22. Referring to FIG. 3A, the first capacitor C1, the first inductor L1, the second inductor L2, and the second capacitor C2 may be sequentially connected in series to one another. The transmitting side and the receiving side may be isolated from each other through the first capacitor C1 and the second capacitor C2, and the first capacitor C1 and the second capacitor C2 may each have an isolation voltage according to requirements.

When the first capacitor C1 and the second capacitor C2 have high capacitances to increase the transmission characteristics of a signal, a malfunction due to the first capacitor C1 and the second capacitor C2 may occur. For example, when a great voltage change (i.e., high dv/dt) occurs in a driver operating based on the receiver 160 or the output signal of the receiver 160, a large current may be transmitted to the transmitter 120 of FIG. 1 through the first capacitor and/or the second capacitor C2, which may cause the circuit included in the transmitter 120 to malfunction or be damaged.

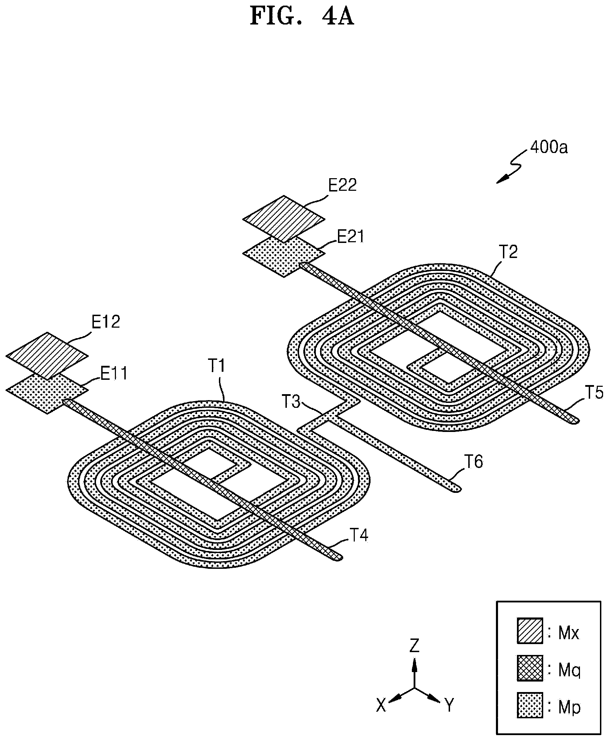

The first inductor L1 and the second inductor L2 may be used to generate a modulated signal MOD resonating in the input terminals P11 and P12. When a resonant circuit having the same resonant frequency is provided on the receiving side, the induced signal MOD' may be weakly attenuated or not be attenuated from the modulated signal MOD, and accordingly, due to an improved signal to noise ratio (SNR), the induced signal MOD' may be easily processed in the receiving side. The capacitances of the first capacitor C1 and the second capacitor C2 may be limited due to the resonant frequency defined by the first inductor L1 and the second inductor L2, and accordingly, the effect resulting from a great voltage change (that is, a high dv/dt) may be reduced. Examples of galvanic isolator 300a of FIG. 3A will be described later with reference to FIGS. 4A to 4C.

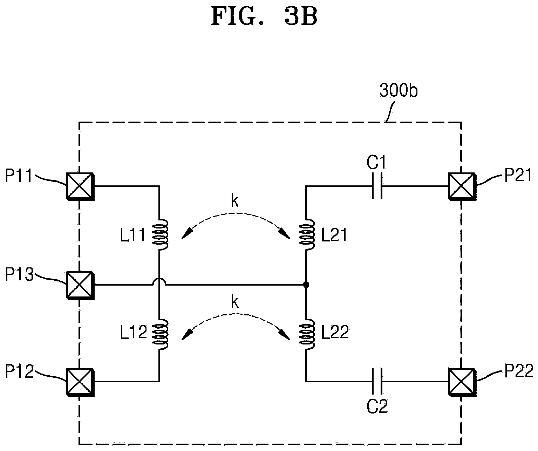

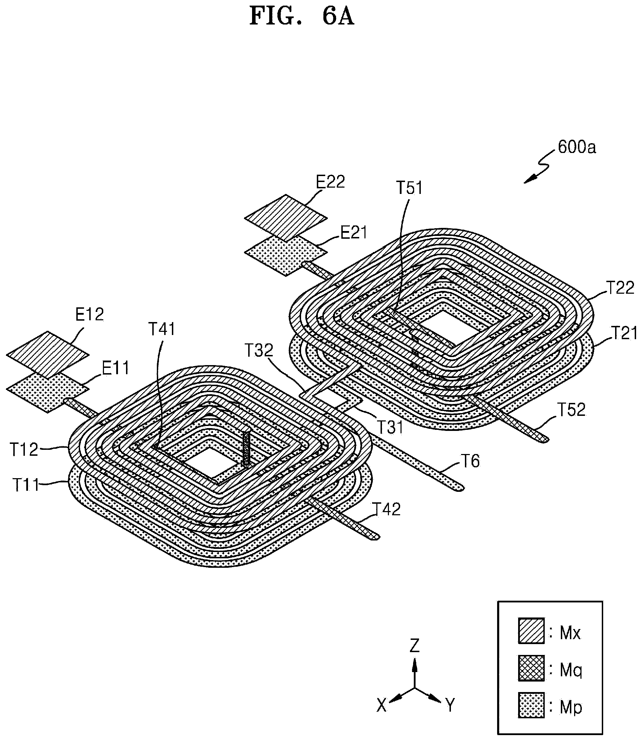

Referring to FIG. 3B, the galvanic isolator 300b may include inductors L11 and L12 connected in series to each other and inductors L21 and L22 connected to each other. The inductors L11 and L12 may be inductively coupled to the inductors L21 and L22, respectively, and may have a coupling coefficient k. Accordingly, the alternating current signal (i.e., an alternating current component of the induced signal MOD') corresponding to the alternating current signal (i.e., an alternating current component of the modulated signal MOD) applied to the terminals P11 and P12 may be generated in the terminals P21 and P22 through the first capacitor C1 and the second capacitor C2. In this case, the inductively coupled inductors may deliver high frequency signals, and the first capacitor C1 and the second capacitor C2 may satisfy the isolation voltage. Similarly, the alternating current signal (i.e., the alternating current component of the modulated signal MOD) may be generated in the terminals P11 and P12 and may correspond to the alternating current signal applied to the inductors L21 and L22 through the first capacitor C1 and the second capacitor C2 from the alternating current signal. Similarly to the description above with reference to FIG. 3A, inductors L11, L12 and inductors L21 and L22 may be used to generate resonant signals. Examples of galvanic isolator 300b of FIG.3B will be described later with reference to FIGS. 6A to 6C.

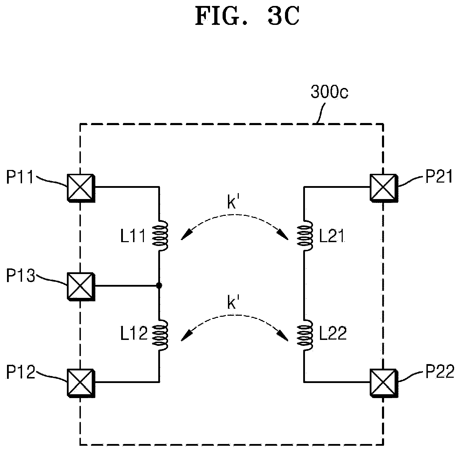

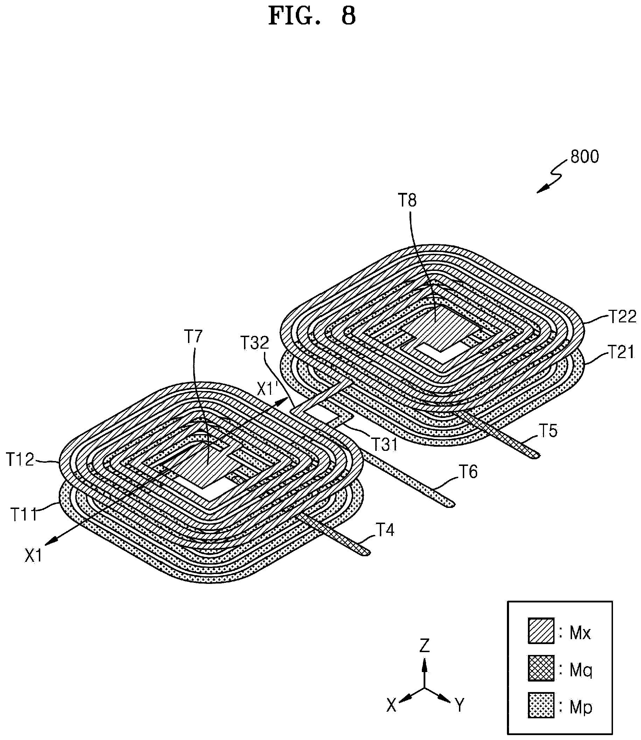

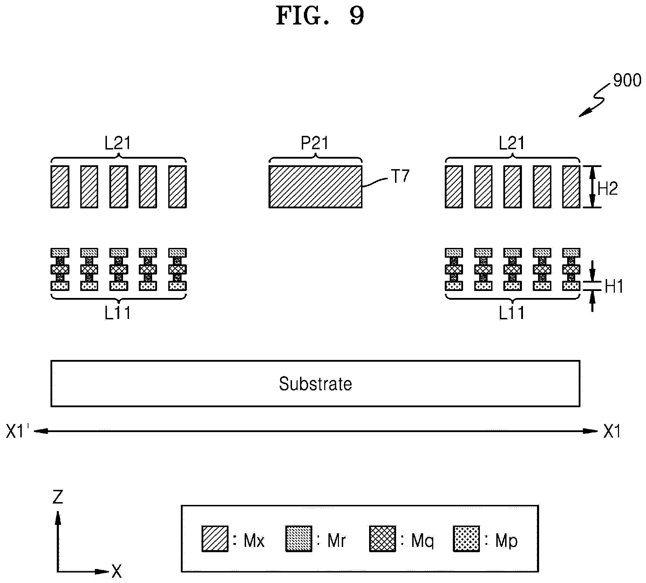

Referring to FIG. 3C, the galvanic isolator 300c may include the inductors L11 and L12 connected to each other and the inductors L21 and L22 connected to each other. The inductors L11 and L12 may be inductively coupled to the inductors L21 and L22, respectively, and may have a coupling coefficient k'. Accordingly, the alternating current signal (i.e., an alternating current component of the induced signal MOD') may be generated in the terminals P21 and P22 and may correspond to the alternating current signal (i.e., an alternating current component of the modulated signal MOD). In this case, since the inductively coupled inductors need to deliver high frequency signals and simultaneously satisfy the isolation voltage, the inductors L11 and L21 and the inductors L12 and L22 may be apart from each other at an appropriate distance to satisfy the isolation voltage. Similarly, the alternating current signal (i.e., the alternating current component of the induced signal MOD') may be generated in the terminals P11 and P12 and may correspond to the alternating current signal applied to the inductors L21 and L22 from the alternating current signal (i.e., the alternating current component of the modulated signal MOD) applied to the terminals P21 and P22. Similarly to the description above with reference to FIG. 3A, the inductors L11, L12 and the inductors L21 and L22 may be used to generate a resonant signal. Examples of galvanic isolator 300c of FIG. 3C will be described later with reference to FIGS. 8 and 9.

In the galvanic isolator 300a of FIG. 3A and the galvanic isolator 300b of FIG. 3B, the maintaining insulation may be provided by the capacitors C1 and C2, and, in the galvanic isolator 300c of FIG. 3C, the maintaining insulation may be provided by the physical separation distance between the inductively coupled inductors. In all the galvanic isolators 300a, 300b, and 300c, the amount of current according to a voltage change (i.e., dv/dt) may be determined mainly by the parasitic capacitor. For example, the amount of current in the galvanic isolator 300a of FIG. 3A and the galvanic isolator 300b of FIG. 3B may be determined by the capacitors C1 and C2, and the amount of current in the galvanic isolator 300c of FIG. 3C may be determined by the parasitic capacitor between the inductively coupled inductors. Therefore, in the galvanic isolator 300a of FIG. 3A and a galvanic isolator 300b of FIG. 3B, the capacitance of the capacitors C1 and C2 may be set arbitrarily, but in the galvanic isolator 300c of FIG. 3C, determining the capacitance may not be easy because the area of the inductor, the insulation separation distance, and the dielectric constant of the insulator may be affective. Thus, the galvanic isolator 300a of FIG. 3A and the galvanic isolator 300b of FIG. 3B may facilitate current control by the voltage change (i.e., dv/dt).

FIGS. 4A to 4C are each a perspective view illustrating an example of the galvanic isolator, according to embodiments. For example, the perspective views of FIGS. 4A to 4C show examples of the galvanic isolator 300a of FIG. 3A. As mentioned above with reference to FIG. 3A, galvanic isolators 400a to 400c may be based on differential signals and may have balanced structures. For example, the first inductor L1 and the second inductor L2 may have the same (e.g., a symmetrical) structure. Hereinafter, FIGS. 4A to 4C will be described with reference to FIG. 3A, and the descriptions of aspects that overlap each other in FIGS. 4A to 4C will be omitted.

Referring to FIG. 4A, the galvanic isolator 400a may be included in an integrated circuit manufactured by a semiconductor process. For example, an integrated circuit may include a plurality of conductive layers formed and stacked by a series of sub-processes included in the semiconductor process, and the galvanic isolator 400a may include patterns disposed in the conductive layers. As shown in FIG. 4A, the first inductor L1 may include a first pattern T1 disposed in a first conductive layer Mp, and the second inductor L2 may include a second pattern T2 disposed in the first conductive layer Mp. The galvanic isolator 400a may include a third pattern T3 connecting the first inductor L1, that is, the first pattern T1 to the second inductor L2, that is, the second pattern T2 in the first conductive layer Mp, and a sixth pattern T6 connected to the third pattern T3 may correspond to the center tab.

The first capacitor C1 may include a first electrode E11 disposed in the first conductive layer Mp and a second electrode E12 disposed in a second conductive layer Mx above the first conductive layer Mp. Similarly, the second capacitor C2 may include a first electrode E21 disposed in the first conductive layer Mp and a second electrode E22 disposed in the second conductive layer Mx. The second electrode E12 of the first capacitor C1 may correspond to the terminal P21 of FIG. 3A, and the second electrode E22 of the second capacitor C2 may correspond to the terminal P22 of FIG. 3A. In some embodiments, the second electrode E12 of the first capacitor C1 and the second electrode E22 of the second capacitor C2 may be exposed to the outside of the integrated circuit to be pads to which a bonding wire is connected or to be connected to the pads.

The galvanic isolator 400a may include a fourth pattern T4 extending in a third conductive layer Mq between the first conductive layer Mp and the second conductive layer Mx to connect the first electrode E11 of the first capacitor C1 to the first inductor L1, and the fourth pattern T4 may correspond to the terminal P11 of FIG. 3A. In addition, the galvanic isolator 400a may include a fifth pattern T5 extending in the third conductive layer Mq to connect the first electrode E21 of the second capacitor C2 to the second inductor L2, and the fifth pattern T5 may correspond to the terminal P12 of FIG. 3A. In some embodiments, the fourth pattern T4 and the fifth pattern T5 may be disposed in a conductive layer under the first conductive layer Mp.

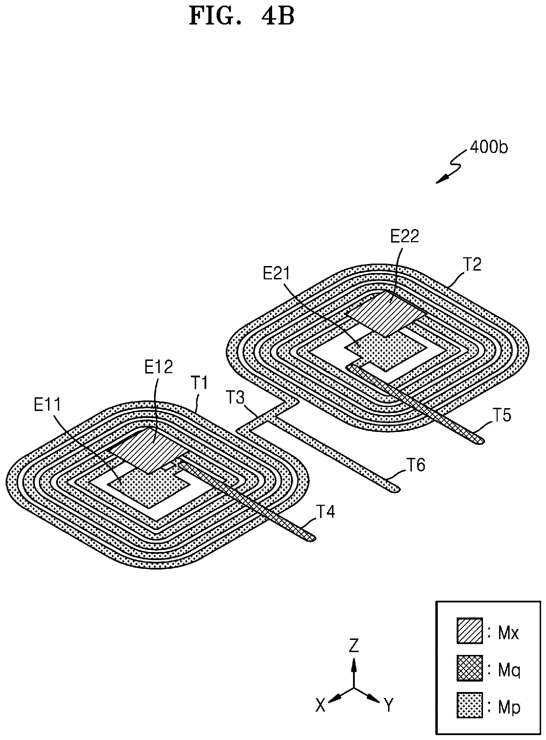

Referring to FIG. 4B, the first inductor L1 may include the first pattern T1 disposed in the first conductive layer Mp, and the second inductor L2 may include the second pattern T2 disposed in the first conductive layer Mp. The galvanic isolator 400b may include the third pattern T3 connecting the first inductor L1, that is, the first pattern T1 to the second inductor L2, that is, the second pattern T2 in the first conductive layer Mp, and the sixth pattern T6 connected to the third pattern T3 may correspond to the center tab.

The first capacitor C1 may include the first electrode E11 disposed in the first conductive layer Mp and the second electrode E12 disposed in the second conductive layer Mx. Similarly, the second capacitor C2 may include the first electrode E21 disposed in the first conductive layer Mp and the second electrode E22 disposed in the second conductive layer Mx. The galvanic isolator 400b may include the fourth pattern T4 electrically connected to the first electrode E11 of the first capacitor C1 and the first inductor L1 and extending in the third conductive layer Mq, and may include the fifth pattern T5 electrically connected to the first electrode E21 of the second capacitor C2 and the second inductor L2 and extending in the third conductive layer Mq. In some embodiments, the fourth pattern T4 and the fifth pattern T5 may be disposed in a conductive layer under the first conductive layer Mp.

Comparing with the galvanic isolator 400a of FIG. 4A, in the galvanic isolator 400b of FIG. 4B, the first electrode E11 of the first capacitor C1 may be surrounded by a first pattern T1 of the first inductor L1, and may overlap the second electrode E12 of the first capacitor C1 in a vertical direction, that is, the Z-axis direction. Similarly, the first electrode E21 of the second capacitor C2 may be surrounded by the second pattern T2 of the second inductor L2 and may overlap the second electrode E22 of the second capacitor C2 in a vertical direction, that is, the Z-axis direction. Accordingly, the galvanic isolator 400b may have a reduced area.

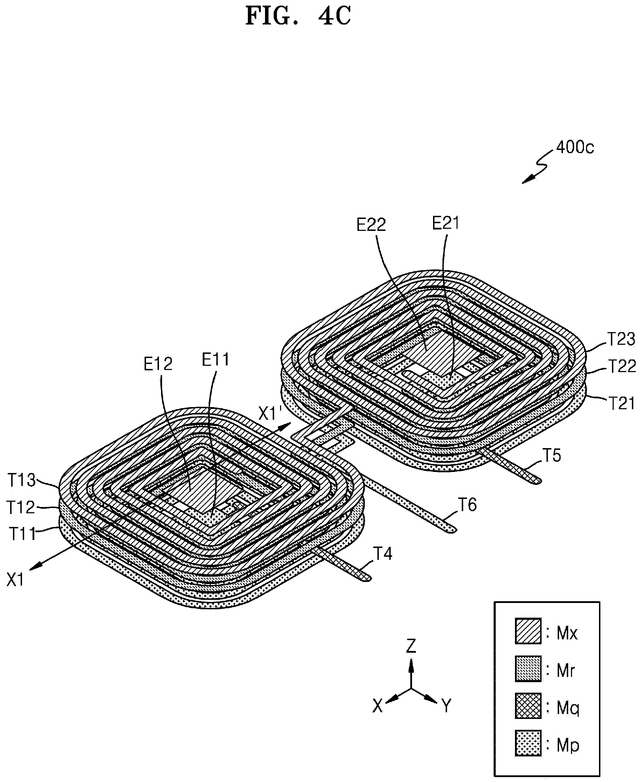

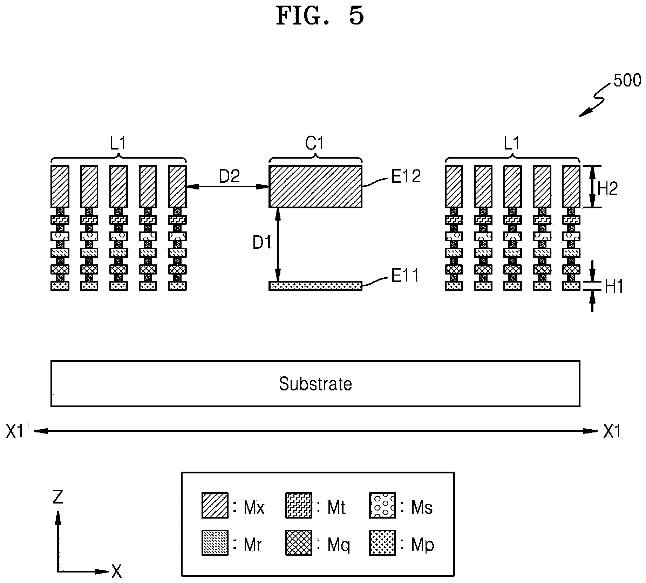

Referring to FIG. 4C, the first inductor L1 may include a pattern T11 disposed in the first conductive layer Mp, a pattern T13 disposed in the second conductive layer Mx, and a pattern T12 disposed in a fourth conductive layer Mr between the first conductive layer Mp and the second conductive layer Mx. In some embodiments, the patterns T11, T12, and T13 may have the same shape in planes including an X-axis and a Y-axis, and may be connected to one another through vias. Accordingly, the first inductor L1 may have a reduced parasitic resistance. Similarly, the second inductor L2 may include a pattern T21 disposed in the first conductive layer MP, a pattern T23 disposed in the second conductive layer Mx, and a pattern T22 disposed in the fourth conductive layer Mr. The patterns T11, T12, and T13 may have the same shape in planes including an X-axis and a Y-axis, and may be connected to one another through vias. Accordingly, the second inductor L2 may have a reduced parasitic resistance. For convenience of illustration, only the patterns T12 and T22 disposed in one conductive layer between the first conductive layer Mp and the second conductive layer Mx, that is, the fourth conductive layer Mr, are illustrated. However, as described below with reference to FIG. 5, each of the first inductor L1 and the second inductor L2 may include the patterns disposed in the plurality of conductive layers between the first conductive layer Mp and the second conductive layer Mx. As shown in FIG. 4C, the patterns T11, T12, and T13 of the first inductor L1 may be connected to the patterns T21, T22, and T23 of the second inductor L2, respectively, and the sixth pattern T6 may correspond to the center tab.

The first capacitor C1 may include the first electrode E11 disposed in the first conductive layer Mp and the second electrode E12 disposed in the second conductive layer Mx. Similarly, the second capacitor C2 may include the first electrode E21 disposed in the first conductive layer Mp and the second electrode E22 disposed in the second conductive layer Mx. The galvanic isolator 400c may include the fourth pattern T4 electrically connected to the first electrode E11 of the first capacitor C1 and the first inductor L1 and extending in the third conductive layer Mq, and may include the fifth pattern T5 electrically connected to the first electrode E21 of the second capacitor C2 and the second inductor L2 and extending in the third conductive layer Mq. In some embodiments, the fourth pattern T4 and the fifth pattern T5 may be disposed in a conductive layer under the first conductive layer Mp.

FIG. 5 is a cross-sectional view of the galvanic isolator 500 taken along line X1-X1' of FIG. 4C, according to an embodiment. Hereinafter, FIG. 5 will be described with reference to FIGS. 3A and 4C.

Referring to FIG. 5, the first inductor L1 may include a pattern disposed in the first conductive layer Mp and a pattern disposed in the second conductive layer Mx, and may include patterns disposed in each of the conductive layers between the first conductive layer Mp and the second conductive layer Mx. Among the patterns of the first inductor L1, the two patterns adjacent in the vertical direction, that is, the Z-axis direction, may be connected to each other through a via. Accordingly, the first inductor L1 may have a reduced parasitic resistance.

As shown in FIG. 5, the thickness (or height) H1 of the pattern disposed in the first conductive layer Mp may be less than the thickness (or height) H2 of the pattern disposed in the second conductive layer Mx. An insulator may be filled between the first inductor L1 and the first capacitor C1, and a dielectric may be filled between the first electrode E11 and the second electrode E12 of the first capacitor C1. In some embodiments, a second distance D2 between the second electrode E12 of the first capacitor C1 and the first inductor L1 (or the pattern of the second conductive layer Mx) may be greater than or equal to a first distance D1 between the first electrode E11 and the second electrode E12 of the first capacitor C1.

FIGS. 6A to 6C are each a perspective view illustrating an example of the galvanic isolator, according to an embodiment. For example, the perspective views of FIGS. 6A to 6C show examples of the galvanic isolator 300b of FIG. 3B. As mentioned above with reference to FIG. 3B, galvanic isolators 600a to 600c may be based on differential signals and may have balanced structures. For example, the inductors L11 and L12 of FIG. 3B may have the same (e.g., symmetrical) structure, and the inductors L21 and L22 of FIG. 3B may have the same (e.g., symmetrical) structure. Hereinafter, FIGS. 6A to 6C will be described with reference to FIG. 3B, and the descriptions of aspects that overlap each other in FIGS. 6A to 6C will be omitted.

Referring to FIG. 6A, the galvanic isolator 600a may be included in an integrated circuit manufactured by a semiconductor process. For example, an integrated circuit may include a plurality of conductive layers formed and stacked by a series of sub-processes included in the semiconductor process, and the galvanic isolator 600a may include patterns disposed in the conductive layers. As shown in FIG. 6A, the inductor L21 may include the pattern T11 disposed in the first conductive layer Mp, and the inductor L22 may include the pattern T21 disposed in the first conductive layer Mp. In addition, the inductor L11 may include the pattern T12 disposed in the second conductive layer Mx above the first conductive layer Mp, and the inductor L12 may include the pattern T22 disposed in the second conductive layer Mx. The galvanic isolator 600a may include the pattern T31 connecting the pattern T11 with the pattern T21 in the first conductive layer Mp, and may include the pattern T32 connecting the pattern T12 with the pattern T22 in the second conductive layer Mx. The sixth pattern T6 connected to the pattern T31 may correspond to the center tab.

The first capacitor C1 may include the first electrode E11 disposed in the first conductive layer Mp and the second electrode E12 disposed in the second conductive layer Mx. Similarly, the second capacitor C2 may include the first electrode E21 disposed in the first conductive layer Mp and the second electrode E22 disposed in the second conductive layer Mx. The second electrode E12 of the first capacitor C1 may correspond to the terminal P21 of FIG. 3B, and the second electrode E22 of the second capacitor C2 may correspond to the terminal P22 of FIG. 3B. In some embodiments, the second electrode E12 of the first capacitor C1 and the second electrode E22 of the second capacitor C2 may be exposed to the outside of the integrated circuit to be pads to which a bonding wire is connected or to be connected to the pads.

The galvanic isolator 600a may include a pattern T41 connected to the first electrode E11 of the first capacitor C1 and the inductor L21 in the third conductive layer Mq between the first conductive layer Mp and the second conductive layer Mx, and may include a pattern T42 connected to the inductor L11 through a via, wherein the pattern T42 may correspond to the terminal P11 of FIG. 3B. In addition, in the third conductive layer Mq, the galvanic isolator 600a may include a pattern T51 connected to the first electrode E21 of the second capacitor C2 and the inductor L22, and may include a pattern T52 connected to the inductor L12 through a via, wherein the pattern T52 may correspond to the terminal P12 of FIG. 3B. In some embodiments, the patterns T41, T42, T51, and T52 may be disposed in a conductive layer under the first conductive layer Mp.

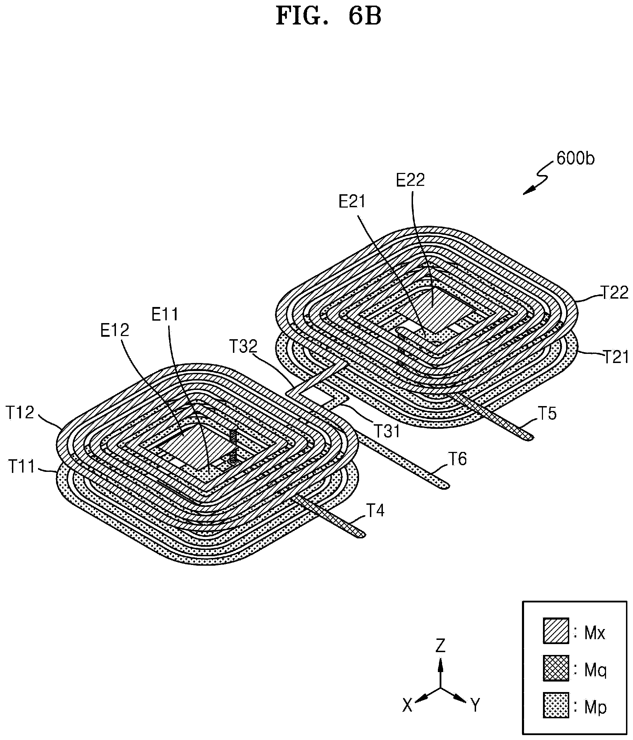

Referring to FIG. 6B, the inductor L21 may include the pattern T11 disposed in the first conductive layer Mp, and the inductor L22 may include the pattern T21 disposed in the first conductive layer Mp. The inductor L11 may include the pattern T12 disposed in the second conductive layer Mx, and the inductor L12 may include the pattern T22 disposed in the second conductive layer Mx. The galvanic isolator 600b may include the pattern T31 connecting the pattern T11 with the pattern T21 in the first conductive layer Mp, and may include the pattern T32 connecting the pattern T12 with the pattern T22 in the second conductive layer Mx. The sixth pattern T6 connected to the pattern T31 may correspond to the center tab.

The galvanic isolator 600b may include the fourth pattern T4 disposed in the third conductive layer Mq and connected to the pattern T12 through a via, and the fifth pattern T5 disposed in the third conductive layer Mq and connected to the pattern T22 through a via. The fourth and fifth patterns T4 and T5 may correspond to the terminals P11 and P12 of FIG. 3B, respectively. In some embodiments, the fourth and fifth patterns T4 and T5 may be disposed in a conductive layer under the first conductive layer Mp.

Comparing with the galvanic isolator 600a of FIG. 6A, in the galvanic isolator 600b of FIG. 6B, the first electrode E11 of the first capacitor C1 may be surrounded by the pattern T11 of the inductor L21, and the second electrode E12 of the first capacitor C1 may be surrounded by the pattern T12 of the inductor L11. Similarly, the first electrode E21 of the second capacitor C2 may be surrounded by the pattern T21 of the inductor L22, and the second electrode E22 of the second capacitor C2 may be surrounded by the pattern T22 of the inductor L12. Accordingly, the galvanic isolator 600b may have a reduced area.

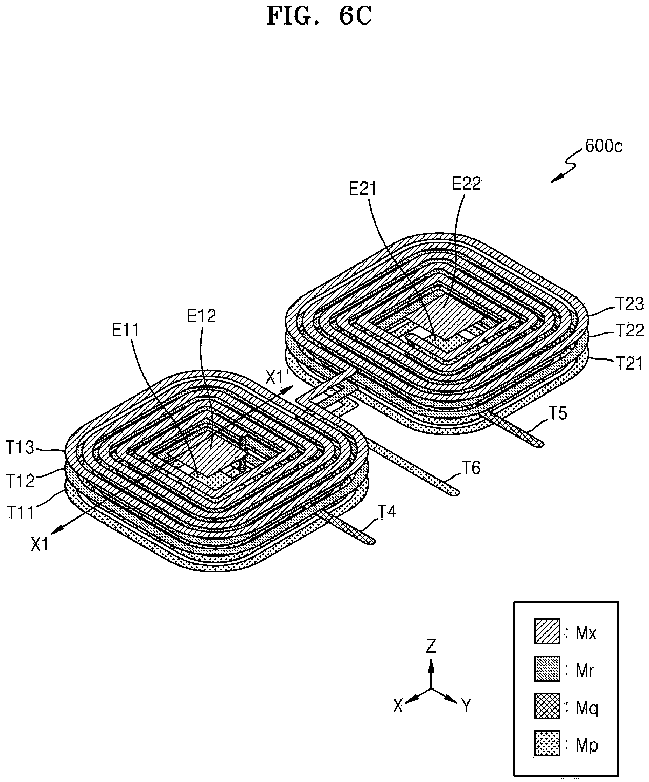

Referring to FIG. 6C, the inductor L21 may include the pattern T11 disposed in the first conductive layer Mp and the pattern T12 disposed in the fourth conductive layer Mr between the first conductive layer Mp and the second conductive layer Mx. In some embodiments, the patterns T11 and T12 may have the same shape in planes including the X-axis and the Y-axis, and may be connected to one another through vias. Accordingly, the inductor L21 may have a reduced parasitic resistance. Similarly, the inductor L22 may include the pattern T21 disposed in the first conductive layer Mp and the pattern T22 disposed in the fourth conductive layer Mr. In some embodiments, the patterns T21 and T22 may have the same shape in planes including the X-axis and the Y-axis, and may be connected to one another through vias. Accordingly, the inductor L22 may have a reduced parasitic resistance.

The inductor L11 may include the pattern T13 disposed in the second conductive layer Mx, and the inductor L12 may include the pattern T23 disposed in the second conductive layer Mx. The galvanic isolator 600c may include patterns that connect the patterns T11 to T13 to the patterns T21 to T23, respectively, and the sixth pattern T6 may correspond to the center tab. In addition, the galvanic isolator 600c may include the fourth pattern T4 disposed in the third conductive layer Mq and connected to the pattern T13 through a via, and the fifth pattern T5 disposed in the third conductive layer Mq and connected to the pattern T23 through a via, wherein the fourth pattern T4 and the fifth pattern T5 may correspond to the terminals P11 and P12 of FIG. 3B, respectively. In some embodiments, the fourth and fifth patterns T4 and T5 may be disposed in a conductive layer under the first conductive layer Mp. The first capacitor C1 may include the first electrode E11 and the second electrode E12, and the second capacitor C2 may include the first electrode E21 and the second electrode E22. The second electrode E12 of the first capacitor C1 and the second electrode E22 of the second capacitor C2 may correspond to the terminals P21 and P22 of FIG. 3B, respectively.

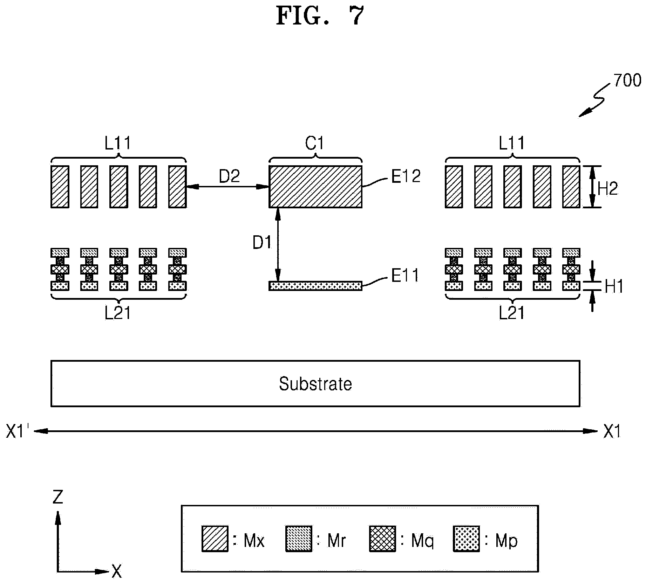

FIG. 7 is a cross-sectional view of the galvanic isolator 700 taken along line X1-X1' of FIG. 6C, according to an embodiment. Hereinafter, FIG. 7 will be described with reference to FIGS. 3B and 6C.

Referring to FIG. 7, the thickness (or height) H1 of the pattern disposed in the first conductive layer Mp may be less than the thickness (or height) H2 of the pattern disposed in the second conductive layer Mx. The inductor L11 may include a pattern disposed in the second conductive layer Mx, and the inductor L21 may include a pattern disposed in the first conductive layer Mp and patterns disposed in the conductive layers Mq and Mr above the first conductive layer Mp. Among the patterns of the inductor L21, the two patterns adjacent in the vertical direction, that is, the Z-axis direction, may be connected to each other through vias. Accordingly, the parasitic resistance of the inductor L21 may be reduced, and the impact caused by the difference between the thicknesses H1 and H2 may be reduced.

An insulator may be filled between the inductors L1 and L21 and the first capacitor C1, and a dielectric may be filled between the first electrode E11 and the second electrode E12 of the first capacitor C1. In some embodiments, the second distance D2 between the second electrode E12 of the first capacitor C1 and the inductor L11 may be greater than or equal to the first distance D1 between the first electrode E11 and the second electrode E12 of the first capacitor C1.

FIG. 8 is a perspective view illustrating an example of the galvanic isolator according to an embodiment. For example, the perspective view of FIG. 8 shows an example of the galvanic isolator 300c of FIG. 3C. As mentioned above with reference to FIG. 3C, a galvanic isolator 800 may be based on a differential signal and may have a balanced structure. For example, the inductors L11 and L12 of FIG. 3C may have the same (e.g., symmetrical) structure, and the inductors L21 and L22 of FIG. 3C may have the same (e.g., symmetrical) structure. Hereinafter, FIG. 8 will be described with reference to FIG. 3C.

Referring to FIG. 8, the galvanic isolator 800 may be included in an integrated circuit manufactured by a semiconductor process. For example, an integrated circuit may include a plurality of conductive layers formed and stacked by a series of sub-processes included in the semiconductor process, and the galvanic isolator 800 may include patterns disposed in the conductive layers. As shown in FIG. 8, the inductor L11 may include the pattern T1 disposed in the first conductive layer Mp, and the inductor L12 may include the pattern T2 disposed in the first conductive layer Mp. In addition, the inductor L21 may include the pattern T12 disposed in the second conductive layer Mx above the first conductive layer Mp, and the inductor L22 may include the pattern T22 disposed in the second conductive layer Mx. The galvanic isolator 800 may include the pattern T31 connecting the pattern T11 and the pattern T21 in the first conductive layer Mp and may include the pattern T32 connecting the pattern T12 and the pattern T22 in the second conductive layer Mx. The sixth pattern T6 connected to the pattern T31 may correspond to the center tab.

A pattern T7 may be surrounded by the pattern T12 in the second conductive layer Mx and may correspond to the terminal P21 of FIG. 3C. A pattern T8 may be surrounded by the pattern T22 in the second conductive layer Mx and may correspond to the terminal P22 of FIG. 3C. The galvanic isolator 800 may include, in the third conductive layer Mq between the first conductive layer Mp and the second conductive layer Mx, the pattern T4 connected to the inductor L11 through a via and the pattern T5 connected to the inductor L12 through a via, and the pattern T4 and the pattern T5 may correspond to the terminal P11 and the terminal P12 of FIG. 3C, respectively. In some embodiments, the fourth and fifth patterns T4 and T5 may be disposed in a conductive layer under the first conductive layer Mp.

FIG. 9 is a cross-sectional view of the galvanic isolator 900 taken along line X1-X1' of FIG. 8, according to an embodiment. Hereinafter, FIG. 9 will be described with reference to FIGS. 3C and 8.

Referring to FIG. 9, the thickness (or height) H1 of the pattern disposed in the first conductive layer Mp may be less than the thickness (or height) H2 of the pattern disposed in the second conductive layer Mx. The inductor L21 may include a pattern disposed in the second conductive layer Mx, and the inductor L11 may include a pattern disposed in the first conductive layer Mp and patterns disposed in the conductive layers Mq and Mr above the first conductive layer Mp. Among the patterns of the inductor L11, the two patterns adjacent in the vertical direction, that is, the Z-axis direction, may be connected to each other through vias. Accordingly, the parasitic resistance of the inductor L11 may be reduced, and the impact caused by the difference between the thicknesses H1 and H2 may be reduced. An insulator may be filled between the inductors L11 and L21 and the pattern P21.

FIGS. 10A to 10H are each a diagram illustrating an example of a device, according to embodiments. As described above with reference to the drawings, the galvanic isolator may be included in the integrated circuit, and accordingly, the system 100 of FIG. 1 may be implemented as a device, such as a semiconductor package. Hereinafter, the descriptions of aspects that overlap each other in FIGS. 10A to 10H will be omitted.

Referring to FIG. 10A, a device 1000a may include galvanic isolators 1012 and 1021 having the same structure as that of the galvanic isolator 300a of FIG. 3A, and the galvanic isolators 1012 and 1021 may be connected to each other through a first bonding wire W1 and a second bonding wire W2. The device 1000a may include a first integrated circuit 1010 and a second integrated circuit 1020 that are apart from each other. The integrated circuit may be manufactured by a semiconductor process. For example, the semiconductor process may include a plurality of sub-processes for processing a wafer including a plurality of integrated circuits, and the integrated circuit (a chip or die) may be separated from the wafer through dicing. The device 1 000a may be a multi-chip package (MCP) including two or more chips.

The first integrated circuit 1010 may include a modulator 1011, the galvanic isolator 1012, and a capacitor C13. The modulator 1011 may be included in the same integrated circuit as the galvanic isolator 1012, that is, the first integrated circuit 1010. For example, the modulator 1011 may include patterns disposed in the same conductive layer as the conductive layer in which the pattern included in the inductors L11 and L12 of the galvanic isolator 1012 are formed. The modulator 1011 may generate a differential signal, that is, a positive modulated signal MODp and a negative modulated signal MODn, by modulating the input signal IN. The galvanic isolator 1012 may have a balanced structure and may receive the positive modulated signal MODp and the negative modulated signal MODn from the modulator 1011.

The galvanic isolator 1012 may include the inductors L11 and L12 and capacitors C11 and C12. A first bias voltage V_{B1} based on a first ground potential GND1 may be applied to the center tab through a direct current voltage source. The capacitor C13 may be connected in parallel to the inductors L11 and L12 of the galvanic isolator 1012. Accordingly, a modulated signal having a resonant frequency defined by the capacitor C13 and the inductors L11 and L12, that is, a positive modulated signal MODp and a negative modulated signal MODn, may be generated.

The second integrated circuit 1020 may include the galvanic isolator 1021, a demodulator 1022, and a capacitor C23. The demodulator 1022 may be included in the same integrated circuit as the galvanic isolator 1021, that is, the second integrated circuit 1020. For example, the demodulator 1022 may include patterns disposed in the same conductive layer as the conductive layer in which the pattern included in the inductors L11 and L12 of the galvanic isolator 1021 are formed. The demodulator 1022 may generate an output signal OUT by demodulating a differential signal being an induced signal, that is, the positive induced signal MODp' and the negative induced signal MODn'. The galvanic isolator 1021 may have a balanced structure and may provide the positive induced signal MODp' and the negative induced signal MODn' to the demodulator 1022.

The galvanic isolator 1021 may include the inductors L21 and L22 and capacitors C21 and C22. A second bias voltage V_{B2} based on a second ground potential GND2 may be applied to the center tab through a direct current voltage source. The capacitor C23 may be connected in parallel to the inductors L21 and L22 of the galvanic isolator 1021. The capacitor C23 and the inductors L21 and L22 may define the same resonant frequency as the resonant frequency of the first integrated circuit 1010. Accordingly, an induced signal having a great magnitude in the resonant frequency, that is, a positive induced signal MODp' and a negative induced signal MODn' may be generated.

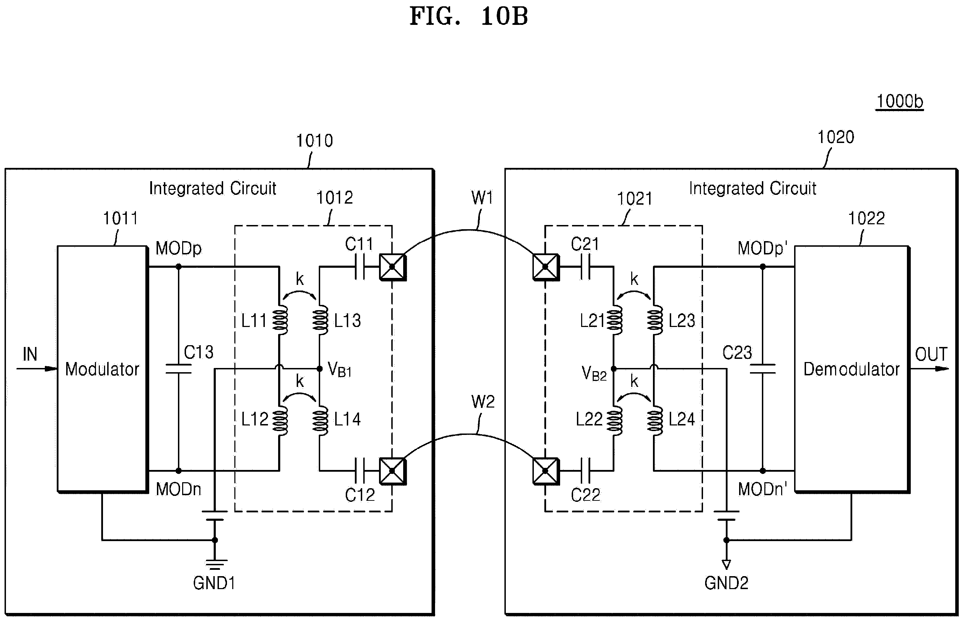

Referring to FIG. 10B, a device 1 000b may include the galvanic isolators 1012 and 1021 having the same structure as that of the galvanic isolator 300b of FIG. 3B, and the galvanic isolators 1012 and 1021 may be connected to each other through the first bonding wire W1 and the second bonding wire W2.

The first integrated circuit 1010 may include the modulator 1011, the galvanic isolator 1012, and the capacitor C13. The capacitor C13 may be connected in parallel to the inductors L11 and L12 of the galvanic isolator 1012. Accordingly, modulated signals, that is, the positive modulated signal MODp and the negative modulated signal MODn, each having a resonant frequency defined by the capacitor C13, the inductors L11 and L12, and the inductors L13 and L14 inductively coupled to the inductors L11 and L12 through the coupling coefficient k, may be generated.

The second integrated circuit 1020 may include the galvanic isolator 1021, the demodulator 1022, and the capacitor C23. The capacitor C23 may be connected in parallel to the inductors L23 and L24 of the galvanic isolator 1021. The capacitor C23, the inductors L23 and L24, and the inductors L21 and L22 inductively coupled to the inductors L23 and L24 through the coupling coefficient k may define the same resonant frequency as the resonant frequency of the first integrated circuit 1010. Accordingly, an induced signal having a great magnitude in the resonant frequency, that is, a positive induced signal MODp' and a negative induced signal MODn' may be generated.

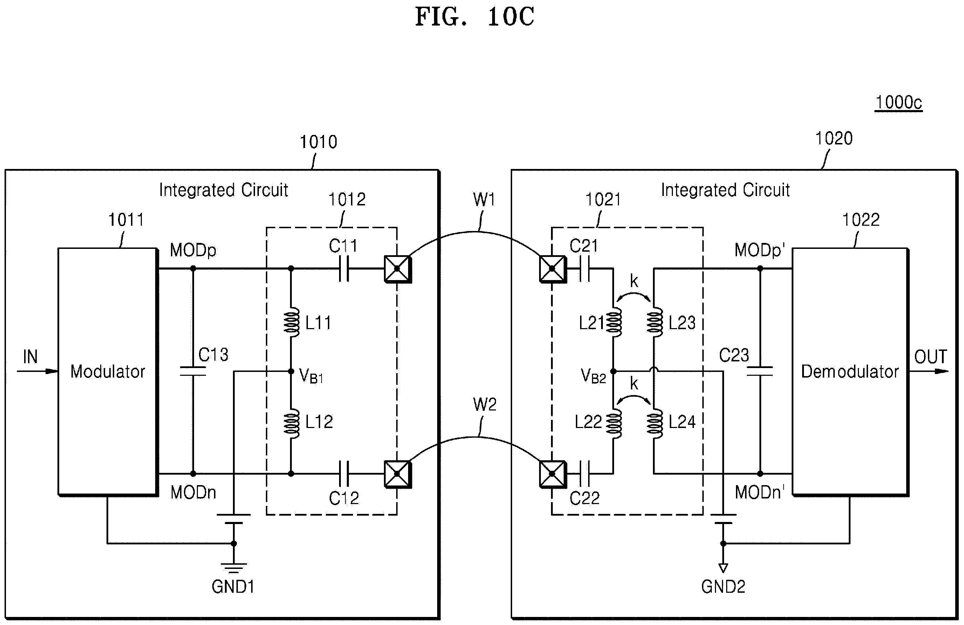

Referring to FIG. 10C, a device 1000c may include the galvanic isolator 1012 having the same structure as the galvanic isolator 300a of FIG. 3A and the galvanic isolator 1021 having the same structure as the galvanic isolator 300b of FIG. 3B. In addition, the galvanic isolators 1012 and 1021 may be connected to each other through the first bonding wire W1 and the second bonding wire W2.

The first integrated circuit 1010 may include the modulator 1011, the galvanic isolator 1012, and the capacitor C13. The capacitor C13 may be connected in parallel to the inductors L11 and L12 of the galvanic isolator 1012. Accordingly, a modulated signal having a resonant frequency defined by the capacitor C13 and the inductors L11 and L12, that is, a positive modulated signal MODp and a negative modulated signal MODn, may be generated.

The second integrated circuit 1020 may include the galvanic isolator 1021, a demodulator 1022, and a capacitor C23. The capacitor C23 may be connected in parallel to the inductors L23 and L24 of the galvanic isolator 1021. The capacitor C23, the inductors L23 and L24, and the inductors L21 and L22 inductively coupled to the inductors L23 and L24 through the coupling coefficient k may define the same resonant frequency as the resonant frequency of the first integrated circuit 1010. Accordingly, an induced signal having a great magnitude in the resonant frequency, that is, a positive induced signal MODp' and a negative induced signal MODn' may be generated.

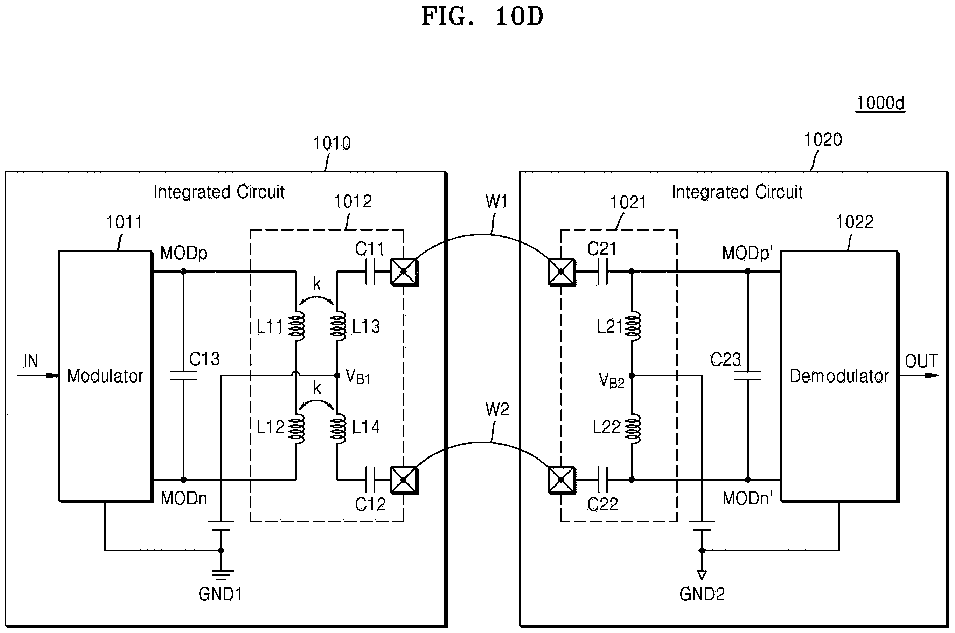

Referring to FIG. 10D, a device 1000d may include the galvanic isolator 1012 having the same structure as the galvanic isolator 300b of FIG. 3B and the galvanic isolator 1021 having the same structure as the galvanic isolator 300a of FIG. 3A. In addition, the galvanic isolators 1012 and 1021 may be connected to each other through the first bonding wire W1 and the second bonding wire W2.

The first integrated circuit 1010 may include the modulator 1011, the galvanic isolator 1012, and the capacitor C13. The capacitor C13 may be connected in parallel to the inductors L11 and L12 of the galvanic isolator 1012. Accordingly, modulated signals, that is, the positive modulated signal MODp and the negative modulated signal MODn, each having a resonant frequency defined by the capacitor C13, the inductors L11 and L12, and the inductors L13 and L14 inductively coupled to the inductors L11 and L12 through the coupling coefficient k, may be generated.

The second integrated circuit 1020 may include the galvanic isolator 1021, a demodulator 1022, and a capacitor C23. The capacitor C23 may be connected in parallel to the inductors L21 and L22 of the galvanic isolator 1021. The capacitor C23 and the inductors L21 and L22 may define the same resonant frequency as the resonant frequency of the first integrated circuit 1010. Accordingly, an induced signal having a great magnitude in the resonant frequency, that is, a positive induced signal MODp' and a negative induced signal MODn' may be generated.

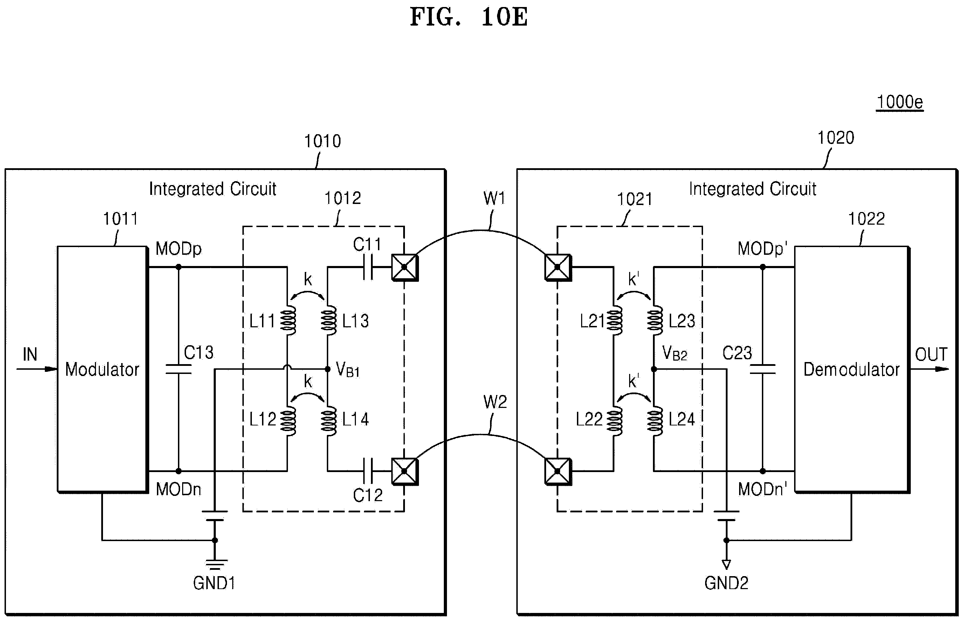

Referring to FIG. 10E, a device 1000e may include the galvanic isolator 1012 having the same structure as the galvanic isolator 300b of FIG. 3B and the galvanic isolator 1021 having the same structure as the galvanic isolator 300c of FIG. 3C. In addition, the galvanic isolators 1012 and 1021 may be connected to each other through the first bonding wire W1 and the second bonding wire W2.

The first integrated circuit 1010 may include the modulator 1011, the galvanic isolator 1012, and the capacitor C13. The capacitor C13 may be connected in parallel to the inductors L11 and L12 of the galvanic isolator 1212. Accordingly, modulated signals, that is, the positive modulated signal MODp and the negative modulated signal MODn, each having a resonant frequency defined by the capacitor C13, the inductors L11 and L12, and the inductors L13 and L14 inductively coupled to the inductors L11 and L12 through the coupling coefficient k, may be generated.

The second integrated circuit 1020 may include the galvanic isolator 1021, the demodulator 1022, and the capacitor C23. The capacitor C23 may be connected in parallel to the inductors L23 and L24 of the galvanic isolator 1021. The capacitor C23, the inductors L23 and L24, and the inductors L21 and L22 inductively coupled to the inductors L23 and L24 through the coupling coefficient k' may define the same resonant frequency as the resonant frequency of the first integrated circuit 1010. Accordingly, an induced signal having a great magnitude in the resonant frequency, that is, a positive induced signal MODp' and a negative induced signal MODn' may be generated.

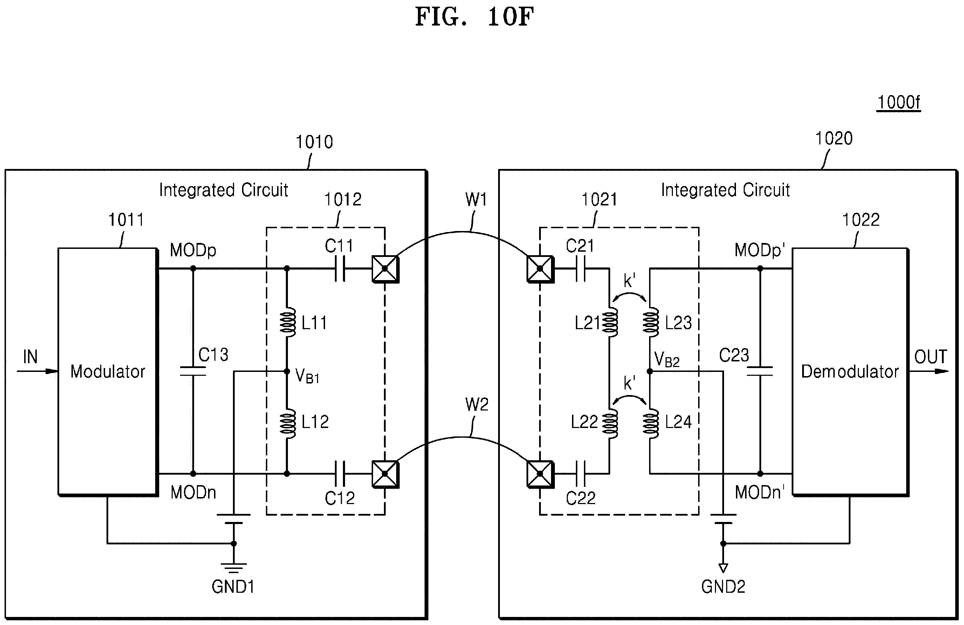

Referring to FIG. 10F, a device 1000f may include the galvanic isolator 1012 having the same structure as the galvanic isolator 300a of FIG. 3A and the galvanic isolator 1021 having the same structure as the galvanic isolator 300c of FIG. 3C. In addition, the galvanic isolators 1012 and 1021 may be connected to each other through the first bonding wire W1 and the second bonding wire W2.

The first integrated circuit 1010 may include the modulator 1011, the galvanic isolator 1012, and the capacitor C13. The capacitor C13 may be connected in parallel to the inductors L11 and L12 of the galvanic isolator 1012. Accordingly, a modulated signal having a resonant frequency defined by the capacitor C13 and the inductors L11 and L12, that is, a positive modulated signal MODp and a negative modulated signal MODn, may be generated.

The second integrated circuit 1020 may include the galvanic isolator 1021, the demodulator 1022, and the capacitor C23. The capacitor C23 may be connected in parallel to the inductors L23 and L24 of the galvanic isolator 1021. The capacitor C23, the inductors L23 and L24, and the inductors L21 and L22 inductively coupled to the inductors L23 and L24 through the coupling coefficient k' may define the same resonant frequency as the resonant frequency of the first integrated circuit 1010. Accordingly, an induced signal having a great magnitude in the resonant frequency, that is, a positive induced signal MODp' and a negative induced signal MODn' may be generated.

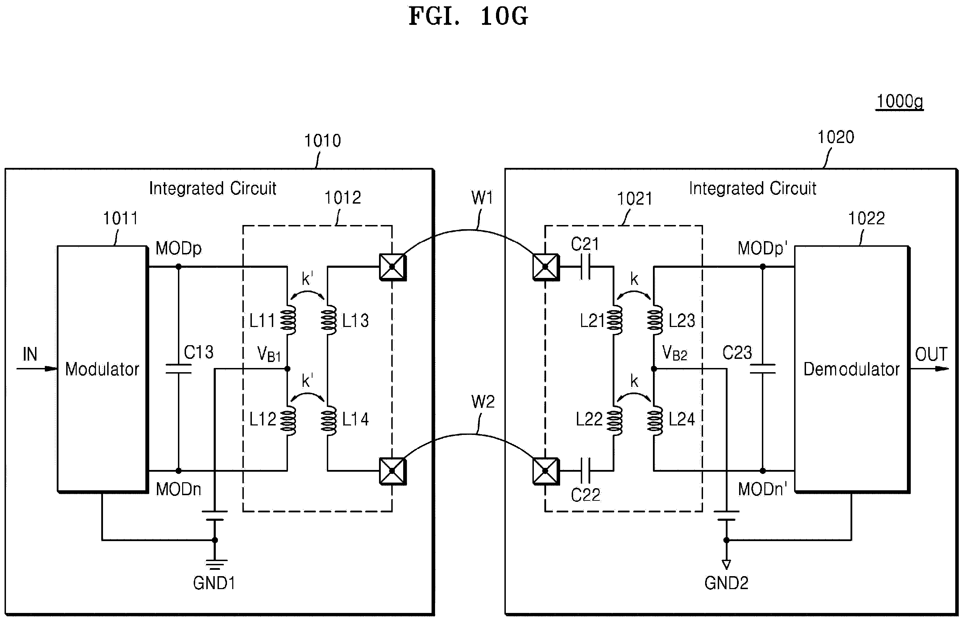

Referring to FIG. 10G, a device 1000g may include the galvanic isolator 1012 having the same structure as the galvanic isolator 300c of FIG. 3C and the galvanic isolator 1021 having the same structure as the galvanic isolator 300b of FIG. 3B. In addition, the galvanic isolators 1012 and 1021 may be connected to each other through the first bonding wire W1 and the second bonding wire W2.

The first integrated circuit 1010 may include the modulator 1011, the galvanic isolator 1012, and the capacitor C13. The capacitor C13 may be connected in parallel to the inductors L11 and L12 of the galvanic isolator 1212. Accordingly, modulated signals, that is, the positive modulated signal MODp and the negative modulated signal MODn, each having a resonant frequency defined by the capacitor C13, the inductors L11 and L12, and the inductors L13 and L14 inductively coupled to the inductors L11 and L12 through the coupling coefficient k', may be generated.

The second integrated circuit 1020 may include the galvanic isolator 1021, the demodulator 1022, and the capacitor C23. The capacitor C23 may be connected in parallel to the inductors L23 and L24 of the galvanic isolator 1021. The capacitor C23, the inductors L23 and L24, and the inductors L21 and L22 inductively coupled to the inductors L23 and L24 through the coupling coefficient k may define the same resonant frequency as the resonant frequency of the first integrated circuit 1010. Accordingly, an induced signal having a large size in the resonant frequency, that is, a positive induced signal MODp' and a negative induced signal MODn' may be generated.

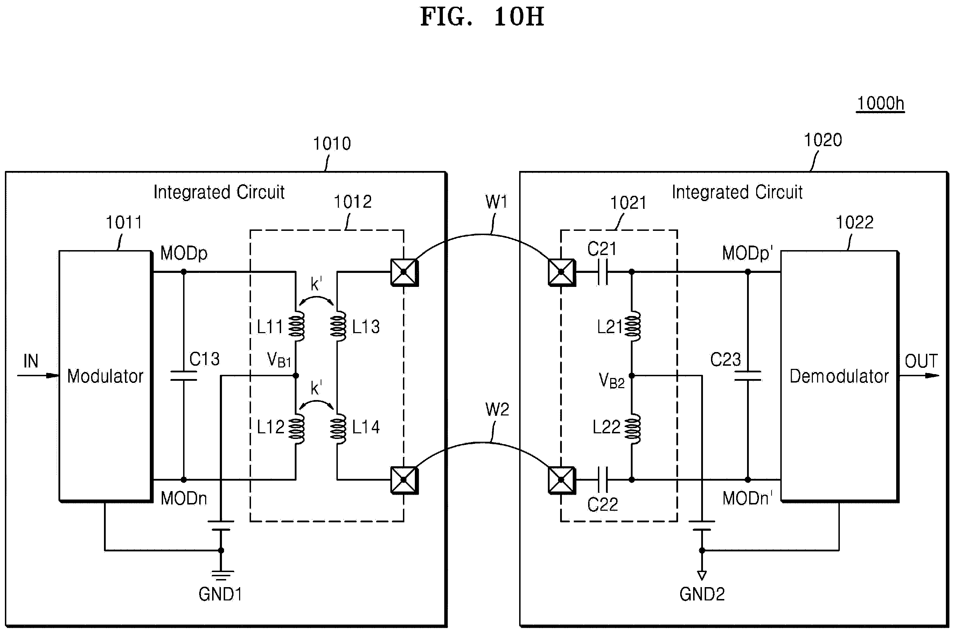

Referring to FIG. 10H, a device 1000h may include the galvanic isolator 1012 having the same structure as the galvanic isolator 300c of FIG. 3C and the galvanic isolator 1021 having the same structure as the galvanic isolator 300a of FIG. 3A. In addition, the galvanic isolators 1012 and 1021 may be connected to each other through the first bonding wire W1 and the second bonding wire W2.

The first integrated circuit 1010 may include the modulator 1011, the galvanic isolator 1012, and the capacitor C13. The capacitor C13 may be connected in parallel to the inductors L11 and L12 of the galvanic isolator 1212. Accordingly, modulated signals, that is, the positive modulated signal MODp and the negative modulated signal MODn, each having a resonant frequency defined by the capacitor C13, the inductors L11 and L12, and the inductors L13 and L14 inductively coupled to the inductors L11 and L12 through the coupling coefficient k, may be generated.

The second integrated circuit 1020 may include the galvanic isolator 1021, the demodulator 1022, and the capacitor C23. The capacitor C23 may be connected in parallel to the inductors L23 and L24 of the galvanic isolator 1021. The capacitor C23 and the inductors L21 and L22 may define the same resonant frequency as the resonant frequency of the first integrated circuit 1010. Accordingly, an induced signal having a great magnitude in the resonant frequency, that is, a positive induced signal MODp' and a negative induced signal MODn' may be generated.

According to the integrated circuit and device according to an embodiment, galvanic isolation may be effectively implemented in the integrated circuit manufactured by a semiconductor process, and accordingly, galvanic isolation may be easily employed in various applications.

In addition, according to the integrated circuit and device according to an embodiment, malfunctioning due to a sudden signal change may be prevented, and thus, galvanic isolation having high reliability may be provided.

The effects obtainable from the embodiments of the disclosure are not limited to the above, and other effects that are not mentioned may be easily derived and understood from the below descriptions by one of ordinary skill in the art. That is, unintended effects resulting from implementing the embodiments of the disclosure may also be derived from the embodiments of the disclosure by one of ordinary skill in the art.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the disclosure as defined by the following claims.

## Claims

1. A device comprising a first integrated circuit, wherein the first integrated circuit comprises:
a first inductor comprising a first pattern disposed in a first conductive layer;
a second inductor disposed in a second conductive layer above the first conductive layer and inductively coupled to the first inductor; and
a first capacitor comprising a first electrode disposed in the first conductive layer and electrically connected to the first inductor and a second electrode disposed in the second conductive layer and electrically connected to a first bonding wire, wherein
the second electrode is insulated from the second inductor.

2. The device of claim 1, wherein the first integrated circuit further comprises:
a third inductor comprising a second pattern disposed in the first conductive layer;
a fourth inductor disposed in the second conductive layer and inductively coupled to the third inductor; and
a second capacitor comprising a third electrode disposed in the first conductive layer and electrically connected to the third inductor and a fourth electrode disposed in the second conductive layer and electrically connected to a second bonding wire, wherein
the third electrode is insulated from the fourth inductor.

3. The device of claim 2, wherein
the first integrated circuit further comprises a third pattern disposed in the first conductive layer and connecting the first pattern to the second pattern, and
the third pattern is electrically connected to a low impedance node.

4. The device of claim 2, wherein the first integrated circuit further comprises a capacitor configured to generate a signal having a resonant frequency based on the second inductor and the fourth inductor.

5. The device of claim 1, wherein the first inductor further comprises:
at least one fourth pattern disposed in at least one conductive layer between the first conductive layer and the second conductive layer; and
vias connecting two adjacent patterns to each other among the first pattern and the at least one fourth pattern.

6. The device of claim 1, wherein
the first electrode is surrounded by the first pattern in the first conductive layer, and
the second electrode is surrounded by the second inductor in the second conductive layer.

7. The device of claim 6, wherein a distance between the second inductor and the second electrode is greater than or equal to a distance between the first electrode and the second electrode.

8. The device of claim 1, further comprising
a second integrated circuit apart from the first integrated circuit, wherein
the first bonding wire connects the first integrated circuit to the second integrated circuit.

9. The device of claim 8, wherein the second integrated circuit comprises:
a fifth inductor having a structure identical to the first inductor;
a sixth inductor having a structure identical to the second inductor; and
a third capacitor having a structure identical to the first capacitor.

10. The device of claim 8, wherein the second integrated circuit comprises:
a seventh inductor comprising a fifth pattern disposed in a third conductive layer; and
a fourth capacitor comprising a fifth electrode disposed in the third conductive layer and electrically connected to the seventh inductor and a sixth electrode disposed in a fourth conductive layer above the third conductive layer and electrically connected to the first bonding wire, wherein
the fifth electrode is surrounded by the fifth pattern in the third conductive layer and overlaps the sixth electrode in a vertical direction.

11. The device of claim 8, wherein the second integrated circuit comprises:
an eighth inductor disposed in a fifth conductive layer;
a ninth inductor comprising a sixth pattern disposed in a sixth conductive layer above the fifth conductive layer and inductively coupled to the first inductor; and
a pattern surrounded by the sixth pattern and electrically connected to the ninth inductor and the first bonding wire.
